(19) **Europäisches Patentamt**
**European Patent Office**
**Office européen des brevets**

(11) **EP 3 591 863 B1**

(12) **EUROPEAN PATENT SPECIFICATION**

(45) Date of publication and mention
of the grant of the patent:
**28.04.2021 Bulletin 2021/17**

(51) Int Cl.:
*H01S 5/00* *(2006.01)*     *H04B 10/50* *(2013.01)*
*H04B 14/02* *(2006.01)*     *H04B 10/524* *(2013.01)*
*H01S 5/026* *(2006.01)*     *H04B 10/54* *(2013.01)*

(21) Application number: **18305881.7**

(22) Date of filing: **05.07.2018**

(54) **ELECTRO-MODULATED STRUCTURES, TRANSMITTERS AND METHODS**

ELEKTRO-MODULIERTE STRUKTUREN, SENDER UND VERFAHREN

STRUCTURES ÉLECTRO-MODULÉES, ÉMETTEURS ET PROCÉDÉS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.01.2020 Bulletin 2020/02**

(73) Proprietor: **Nokia Solutions and Networks Oy
02610 Espoo (FI)**

(72) Inventors:
• **DEBREGEAS, Hélène
91767 Paris (FR)**

• **DUPUY, Jean-Yves
91767 Paris (FR)**
• **Caillaud, Christophe
91767 Paris (FR)**

(74) Representative: **Bryers LLP
7 Gay Street
Bath, Bath and North East Somerset BA1 2PH
(GB)**

(56) References cited:
**US-A1- 2005 275 920     US-A1- 2016 365 929**

EP 3 591 863 B1

## Description

### TECHNICAL FIELD

Aspects relate, in general, to an electro-modulated structure, a transmitter and a method.

### BACKGROUND

Multi-level pulse amplitude modulation (PAM) can be used to modulate a signal in order to encode data by way of a series of signal pulses of varying amplitude. In a datacentre infrastructure, for example, PAM can be used to transmit data over relatively short distances up to the order of several kilometres.

US2016/0365929 discloses multilevel optical intensity modulation performed using electro-absorption optical modulators. There is provided a plurality of electro-absorption (EA) modulators connected in series in a path of an optical signal from a light source, and a multilevel-coded modulated optical signal is generated by modulating an intensity of an input optical signal from the light source based on a modulation signal using the EA modulators. Each of the EA modulators is switched between an ON state and an OFF state of optical absorption in accordance with the modulation signal. Regarding an extinction ratio of the ON state to the OFF state in each of the EA modulators, the EA modulators have respective values difference from each other, and are arranged in ascending order of the extinction ratio from the light source side.

US2005275920 describes an optical transmitter module and an optical module using an EA modulator capable of realizing stable alternating current extinction ration (ACER) regardless of operating temperature without using a control mechanism for maintaining temperature of the EA modulator constant. In the EA modulator, optical waveguides formed of a multi-layered film are formed on a substrate, an electrical signal is applied to the optical waveguides in a direction vertical to the substrate, and the input light absorption amount is changed to control the amount of output light. Also, a plurality of p-side electrodes electrically separated from each other for applying an electrical signal to the active layer optical waveguides are arranged on optical axes of active layer optical waveguides.; The length of optical waveguides to which the electrical signal is applied is changed by controlling the number of p-side electrodes to which the electrical signal is applied in accordance with temperature.

### SUMMARY

According to an embodiment, there is provided an electro-modulated structure, comprising an electro-absorption modulator, and first and second drivers to independently apply respective first and second electric fields to first and second sections of the modulator whereby to modulate an optical signal to generate a multi-level pulse amplitude modulated output signal. The first and second drivers bias the first and second sections of the modulator using respective applied voltages corresponding to minimum and maximum levels of the extinction curves of the first and second sections of the modulator where the derivative d(ER)/dV is null. The first section of the modulator can be shorter than the second section of the modulator. Other dimensions of the modulator can remain the same (e.g. depth, height and so on). Respective lengths, L, of the first and second sections of the modulator can be selected as a function of an extinction ratio, ER, for the sections according to:

$$ ER = \exp(-\Delta\alpha.\Gamma.L/10) $$

where $\Gamma$ is the optical confinement of a mode of the lasing device, and $\Delta\alpha$ is the variation in absorption of a section of the modulator with applied voltage.

The first and second drivers can be synchronised current limiting drivers. The electro-modulated structure can further comprise a single mode lasing device.

According to an example, there is provided a transmitter, comprising the electromodulated structure multi-section electro-absorption modulator.. The first and second drivers are configured to bias the first and second sections of the modulator using respective applied voltages corresponding to minimum and maximum levels of the extinction curves of the first and second sections of the modulator where the derivative d(ER)/dV is null. A laser is monolithically integrated with the multi-section electro-absorption modulator, and the laser is a distributed feedback laser. The laser can generate an optical signal to pass via the first and second sections of the electro-absorption modulator to an output of the transmitter. The first and second sections of the electro-absorption modulator can have respective different lengths.

According to an embodiment, there is provided a method for modulating an optical signal in a optical transmitter to generate a multi-level pulse amplitude modulated output signal, the method comprising biasing first and second sections of an electro-absorption modulator of the transmitter using respective different applied electric fields. The first and second sections of an electro-absorption modulator are biased by applying respective voltages to the sections.

The first and second sections of the electro-absorption modulator are biased at voltages corresponding to minimum and maximum levels of the extinction curves of the first and second sections of the modulator, where the derivative d(ER)/dV is null. In an example, the optical signal can be generated using a lasing device monolithically integrated with the electro-absorption modulator. The first and second sections of the electro-absorption modulator can be biased using selected voltage signals applied to electrodes of the first and second sections of the electro-absorption modulator. The voltage signals can be selected to generate a two-bit sequence for the output signal.

## BRIEF DESCRIPTION OF THE DRAWINGS

Embodiments will now be described, by way of example only, with reference to the accompanying drawings, in which:

Figure 1 is a schematic representation of an electro-modulated structure according to an example;

Figure 2 is a schematic representation of a graph depicting variation of extinction ratio versus modulator bias voltage according to an example;

Figure 3 is a schematic representation of a transmitter according to an example; and

Figure 4 is a flowchart of a method according to an example.

## DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

There is a growing demand for higher speed and more bandwidth over existing infrastructures, such as in datacentres for example. A multi-level PAM signal can be used for, amongst other applications, data communication in such infrastructures over optical links where an optical signal is utilised. For example, PAM4 consists of amplitude modulation over 4 levels.

Compared with standard 2-level modulation (PAM2), this doubles the amount of information per symbol. That is, each symbol corresponds to two bits of information (11, 10, 01, 00). Similarly, PAM8 over 8 levels provides 3 bits per symbol, and PAM16 provides 4 bits per symbol and so on.

To generate such multi-level signals, a multi-level electrical signal can be applied to a signal modulator that is used to amplitude modulate an optical signal. However, this uses complex multilevel electrical signals obtained via multiplexing of two-level electrical signals via dedicated circuits. Furthermore, to enable multi-level modulation, the modulator is designed with a steep extinction curve. Accordingly, when the multi-level electrical signal is applied to the modulator, electrical noise is transferred to the optical signal, leading to noisy eye diagrams and degradation of transmission performance.

For example, a multi-level electrical signal can be applied to an optical modulator using, for example, a Digital to Analog Converter (DAC). This signal can be applied to a Mach-Zehnder modulator (usually Lithium Niobate or Silicon photonics), or to an Electro-Absorption Modulator (EAM). This uses a complex linear driver with a large modulation amplitude. In addition, electrical noise is directly transformed into optical noise due to the steep extinction ratio characteristic of such system.

Another option is to use a Mach-Zehnder modulator with segmented electrodes. For example, in PAM4 modulation, the Mach-Zehnder electrodes can be segmented into 2 portions: a first short portion generates a $\pi/3$ phase shift, and a second relatively longer portion generates a $2\pi/3$ phase shift. PAM4 modulation can thus be generated with two digital drivers. However, Mach-Zehnder modulation is difficult to integrate with a laser source, and so hybrid integration with an external laser is used.

According to an example, there is provided a method for modulating an optical signal using segmented electrodes on a multi-section electro-absorption modulator. The two sections of the EAM can be controlled by two digital drivers, applying different signals to each section.

In an EAM, absorption is directly related to modulator length. Accordingly, a first (relatively shorter) section can provide one third (for example) of the extinction, and a second (relatively longer section) can provide two thirds (for example) of the extinction. Thus, in an example, both sections together provide complete extinction. Other ratios are possible. The modulators can be operated at voltages corresponding to the minimum and maximum levels of their extinction curve, where the derivative d(extinction ratio) / dVoltage is null (or close to null), therefore leading to strong suppression of optical noise.

Thus, according to an example, an optical signal can be modified to generate a multi-level pulse amplitude modulated output signal. First and second sections of an electro-absorption modulator of a transmitter, for example, can be biased using respective different applied electric fields. In an example, electric fields can correspond to the two-bit sequences of PAM4 signal (as PAM4 is generated by concatenating two independent 2-level bit sequences).

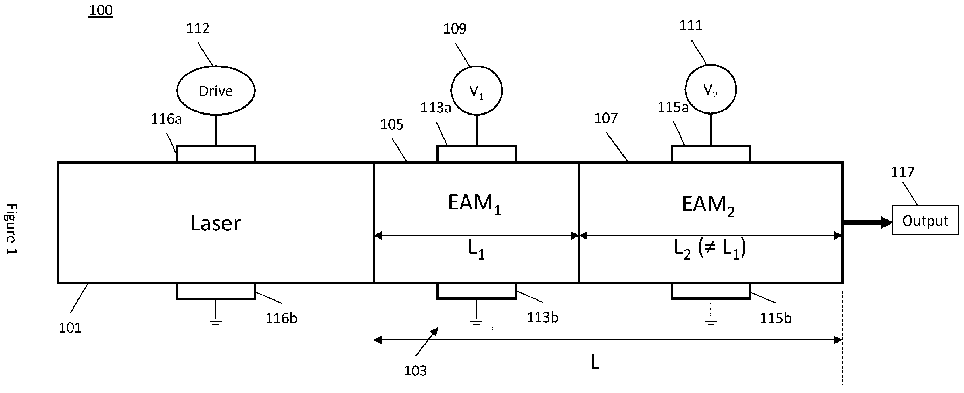

Figure 1 is a schematic representation of an electro-modulated structure according to an example. A laser device 101, such as a single mode lasing device for example, can be integrated with an electro-absorption modulator 103. In an example, the laser device 101 can be monolithically integrated with the electro-absorption modulator 103 to form the electro-modulated structure 100. The laser device 101 and the EAM 103 can be made of the same material using the same technology. In an example, a lasing device and a modulator can be separately fabricated and joined using a butt-joint for example. This can enable independent optimisation of the laser and modulator multi-quantum wells. In another example, a butt-joint between elements of the structure can relate to a monolithically fabricated structure in which both laser and EAMs are formed using the same substrate/wafer. For example, one vertical structure can be grown, say modulator multi-quantum wells (MQWs). Then, these MQWs can be locally etched (with, e.g., a ~1$\mu$m-deep etch), and the laser MQWs can be grown during a subsequent epitaxy stage inside these trenches. Thus, the wafer contains areas with laser or modulator MQWs thereby providing a monolithically integrated laser-modulator (electro-modulated) structure.

In an example, electro-absorption modulator 103 is notionally separated into two sections, $EAM_1$ (105) and $EAM_2$ (107). The length of $EAM_1$ (105) is $L_1$, and the length of $EAM_2$ (107) is $L_2$, where $L_1 \neq L_2$ and $L_1 + L_2 = L$, the overall length of the electro-absorption modulator 103. In the example of figure 1, $L_1 < L_2$, although other alternatives are possible (such as $L_1 > L_2$).

According to an example, $EAM_1$ (105) and $EAM_2$ (107) can be biased by way of applied voltages $V_1$ and $V_2$, as depicted. In the example of figure 1, the voltages can be applied to the EAM sections 105, 107 using respective drivers 109, 111 utilising electrode pairs 113a, 113b, and 115a, 115b so arranged on either side of respective ones of the EAM sections 105, 107 as to provoke formation of respective electric fields upon application of a voltage $V_1$, $V_2$.

By modifying the values of $V_1$ and $V_2$, thereby altering the electric fields present in $EAM_1$ (105) and $EAM_2$ (107), an optical signal, generated using laser 101 by way of a drive signal 112 applied to the laser 101 using, for example, electrodes 116a, 116b, will be absorbed at differing levels within the EAMs 105, 107, thereby enabling the signal to be amplitude modulated over multiple (amplitude) levels, producing a multi-level PAM output signal 117.

In an example, laser and modulator electrodes are electrically isolated. For example, a p-doped top InP material can be partially etched over a length of about 50$\mu$m between sections. Another approach, is to perform H+ ion implantation of p-doped InP between the two sections, which turns it into isolating material.

The extinction ratio (ER) of an EAM of length L (cm) is given by $ER(dB) = \Delta\alpha\Gamma.L$ where $\Gamma$ (%) is the optical confinement of the mode into the absorbing material, and $\Delta\alpha$ (dB/cm) is the absorption variation with applied voltage. Using a linear scale, the extinction ratio of an EAM of length L becomes $ER(linear) = \exp(-\Delta\alpha.\Gamma.L/10)$.

For a PAM4 modulation example, $L_1$ and $L_2$ (see figure 1) can be chosen, in view of the above, such that the ER is about 0.6 (=2.2dB) for $L_1$, and about 0.3 (=5.2dB) for $L_2$, and the EAMs 105, 107 can be biased at 0V (transparency) or at around -1.5V (maximum absorption). When $EAM_1$ and $EAM_2$ are biased at $V_1=V_2=0V$, a light signal from laser 101 is transmitted through the entire EAM 103 without absorption, corresponding to bits "11". When $V_1=-1.5V$ and $V_2=0V$, a light signal from laser 101 is transmitted with 0.6 extinction (=2.2dB), corresponding to bits " 10". When $V_1=0V$ and $V_2=-1.5V$, extinction is 0.3 (=5.2dB) corresponding to bits "01", and when both $V_1=V_2=-1.5V$, extinction is 0.18 (=7.4dB) corresponding to bits "00".

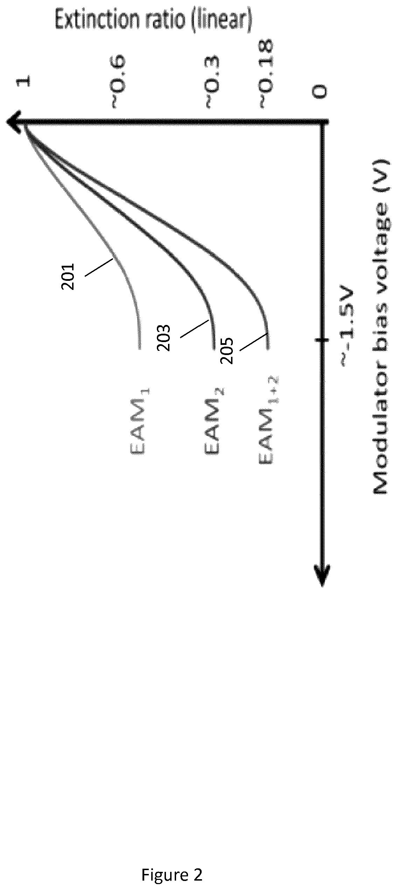

Figure 2 is a schematic representation of a graph depicting variation of extinction ratio versus modulator bias voltage according to an example. Referring to figure 1, the variation for $EAM_1$ is 201, for $EAM_2$ is 203, and for the whole EAM (103) is 205. At a modulator bias voltage of around -1.5V $EAM_1$ provides 0.6 extinction (2.2dB), $EAM_2$ provides 0.3 extinction (5.2dB), and the succession of $EAM_1$ and $EAM_2$ provides 0.18 extinction (~7.5dB).

According to an example, with reference to figure 2, each EAM section of the structure 100 of figure 1 can be modulated between voltages where the slope d(ER)/dV is minimal or null. In the example of figure 2, this occurs around the -1.5V bias region. Electrical noise is then automatically cancelled by the flat characteristic of the ER-V curve around the applied voltages, thereby suppressing optical noise.

In comparison, a single section EAM is biased at voltages where the slope d(ER)/dV is large. In this regime, large amounts of electrical noise are present which directly translates into optical noise. In an example, the extinctions of the two EAM sections 105, 107 of structure 100 are much smaller than for a single EAM configuration (typically 10dB). Thus, the modulator section lengths can be reduced while keeping the same standard vertical structure. Typically, single section EAMs are $75\mu m$-long for 56Gbauds operation. In an example, the lengths of sections of an EAM can be reduced to $L1\sim15\mu m$ and $L_2\sim40\mu m$. These shorter lengths directly reduce the EAM capacities, leading to much higher bandwidth and modulation rates beyond 56Gbauds.

With small extinctions per EAM section, it is possible to keep similar lengths of around $50\text{-}100\mu m$, but to decrease optical confinement $\Gamma$ (i.e. reduce the number of quantum wells). With such a thinner absorbing structure, the same electrical field can be obtained with a smaller voltage. In an example, the applied bias voltage can therefore be decreased to less than -1.5V, thereby reducing power consumption. In addition, lower optical confinement also implies a larger saturation power of the EAM which allows a higher transmitter output power and therefore a larger optical budget.

With the single section EAM, the EAM is operated at small voltages, especially for $V_{10}$ and $V_{01}$, in the upper part of an extinction curve, where the modulator chirp Henry factor is positive. This is detrimental during propagation over standard single mode fibres due to chromatic dispersion for $1.55\mu m$ transmission. However, in an example, the EAM sections of an EAM that is configured with multiple EAM portions can be operated between 0 and -1.5V, where Henry factor ranges from positive to negative value (a null value is typically in the middle of the extinction curve, $\sim$-0.8V). Transmission performance is thus improved.

With reference to figure 1, two simple digital (binary) drivers can be used instead of complex multilevel drivers or DACs. Moreover, a current limiting driver can be used instead of a linear driver, thereby enabling a reduction in the electrical noise on each level. In an example, the drivers are synchronised, whereby to apply selected voltages to modulator sections at the same time, subject to normal tolerances.

For PAM8, PAM16, PAM-N, etc., modulation, the structure according to an example can be extended with 3, 4, log2(N), etc., EAM sections. Furthermore, compared to Mach-Zehnder systems, the structure of figure 1, for example, comprises a multi-section EAM that is monolithically integrated with a single mode laser. The modulation voltages remain limited to only 0 / -1.5V. These modulation voltages can even be further reduced to below 0 / - IV by using thinner absorption layers, as the required extinctions of the two sections are small. By using short EAM sections, the bandwidth can be increased to even more than 56Gbauds.

Compared to single section EAM, better eye diagrams and transmission characteristics are generated as the sections are modulated at voltages where the ER(V) characteristic is flat, and with smaller chirp Henry factor.

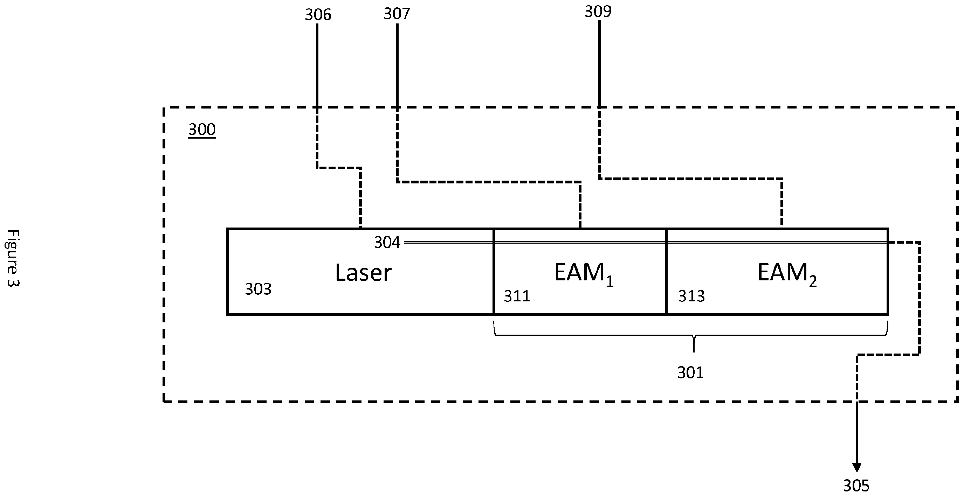

Figure 3 is a schematic representation of a transmitter according to an example. Transmitter 300 comprises a multi-section electro-absorption modulator 301. In an example, the multi-section electro-absorption modulator 301 can be monolithically integrated with a laser device 303. A current applied to the laser device 303 using a connector 306 can be used to generate an optical signal 304 that passes through EAM 301.

Electrodes (e.g. 113a,b; 115a,b) can be used to independently apply a first electric field to a first section, $EAM_1$, of the electro-absorption modulator 301 (using a voltage $V_1$ applied using a connection 307), and a second electric field to a second section, $EAM_2$, of the electro-absorption modulator 301 (using a voltage $V_2$ applied using a connection 309). As a result of the electric fields, the absorption of the EAM sections 311, 313, can be controlled or modified, thereby modulating the intensity of the optical signal 304 as it traverses the length of the EAM sections 311, 313. Accordingly, by controlling the electric fields across the EAM sections 311, 313, the optical signal 304 can be modulated to generate a multi-level modulated output signal 305 representing a multi-level PAM signal.

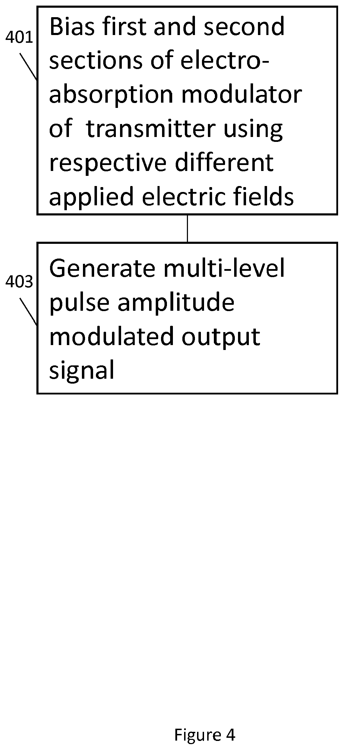

Figure 4 is a flowchart of a method according to an example. In block 401 first and second sections of an electro-absorption modulator of a transmitter are biased using respective different applied electric fields. For example, referring to figures 1 and 3, sections $EAM_1$ (105, 311) and $EAM_2$ (107, 313) can be biased by applying a selected voltage using electrodes. According to an example, as described above, each EAM section can be so biased as to result in a section being effectively transparent or maximally absorptive. Accordingly, each section can be used to alter the intensity of an optical signal in order to modulate it, thereby generating a signal representing bits of a data stream. In an example, the first and second electric fields correspond to the two-bit sequences of PAM4 signal, as PAM4 is generated by concatenating two independent 2-level bit sequences. Thus, in block 403, a multi-level pulse amplitude modulated output signal is generated.

The present inventions can be embodied in other specific apparatus and/or methods. The described embodiments are to be considered in all respects as illustrative and not restrictive. In particular, the scope of the invention is indicated by the appended claims rather than by the description and figures herein.

**Claims**

1. An electro-modulated structure, comprising:

an electro-absorption modulator; and
first and second drivers to independently apply respective first and second electric fields to first and second sections of the modulator, whereby to modulate an optical signal to generate a multi-level pulse amplitude modulated output signal, **characterised in that** the first and second drivers are configured to bias the first and second sections of the modulator using respective applied voltages corresponding to minimum and maximum levels of the extinction curves of the first and second sections of the modulator.

2. An electro-modulated structure as claimed in claim 1, wherein the first section of the modulator is shorter than the second section of the modulator.

3. An electro-modulated structure as claimed in any preceding claim, wherein respective lengths, L, of the first and second sections of the modulator are selected as a function of an extinction ratio, ER, for the sections according to:

$$ER = \exp(-\Delta\alpha.\Gamma.L/10)$$

where $\Gamma$ is the optical confinement of a mode of the lasing device, and $\Delta\alpha$ is the variation in absorption of a section of the modulator with applied voltage.

4. An electro-modulated structure as claimed in any preceding claim, wherein the first and second drivers are synchronised current limiting drivers.

5. An electro-modulated structure as claimed in any preceding claim, further comprising a single mode lasing device.

6. A transmitter comprising an electro-modulated structure as claimed in claim 1, and a laser monolithically integrated with the electro-absorption modulator, wherein the laser is a distributed feedback laser.

7. A transmitter as claimed in claim 6, wherein the laser is configured to generate an optical signal to pass via the first and second sections of the electro-absorption modulator to an output of the transmitter.

8. A transmitter as claimed in any of claims 6 to 7, wherein the first and second sections of the electro-absorption modulator have respective different lengths.

9. A method for modulating an optical signal in an optical transmitter to generate a multi-level pulse amplitude modulated output signal, the method comprising:
biasing first and second sections of an electro-absorption modulator of the transmitter using respective different applied electric fields, the method **characterised in that** the first and second sections of the electro-absorption modulator are biased at voltages corresponding to minimum and maximum levels of the extinction curves of the first and second sections of the modulator.

10. A method as claimed in claim 9, further comprising biasing the first and second sections of the electro-absorption modulator at voltages corresponding to minimum and maximum levels of the extinction curves of the first and second sections of the modulator, where the derivative d(ER)/dV is null.

11. A method as claimed in any of claims 9 or 10, wherein the first and second sections of the electro-absorption modulator are biased using selected voltage signals applied to electrodes of the first and second sections of the electro-absorption modulator.

12. A method as claimed in claim 11, wherein the voltage signals are selected to generate a two-bit sequence for the output signal.

**Patentansprüche**

1. Elektromodulierte Struktur, die Folgendes umfasst:

einen Elektroabsorptionsmodulator und einen ersten und einen zweiten Treiber zum unabhängigen Anlegen eines jeweiligen ersten und zweiten elektrischen Feldes an einen ersten und einen zweiten Bereich des Modulators, wodurch ein optisches Signal moduliert wird, um ein pulsamplitudenmoduliertes Ausgangssignal mit mehreren Pegeln zu erzeugen, **dadurch gekennzeichnet, dass** der erste und der zweite Treiber dazu ausgelegt sind, den ersten und den zweiten Bereich des Modulators unter Verwendung von jeweiligen angelegten Spannungen, die einem minimalen und einem maximalen Pegel der Extinktionskurven des ersten und des zweiten Bereichs des Modulators entsprechen, vorzuspannen.

2. Elektromodulierte Struktur nach Anspruch 1, wobei der erste Bereich des Modulators kürzer ist als der zweite Bereich des Modulators.

3. Elektromodulierte Struktur nach einem der vorhergehenden Ansprüche, wobei jeweilige Längen, L, des ersten und des zweiten Bereichs des Modulators als eine Funktion eines Extinktionsverhältnisses, ER, für die Bereiche gemäß Folgendem ausgewählt werden:

$$ER = \exp(-\Delta\alpha.\Gamma.L/10)$$

wo $\Gamma$ die optische Begrenzung eines Modus der Laservorrichtung ist und $\Delta\alpha$ die Variation der Absorption eines Bereichs des Modulators mit angelegter Spannung ist.

**4.** Elektromodulierte Struktur nach einem der vorhergehenden Ansprüche, wobei der erste und der zweite Treiber synchronisierte Strombegrenzungstreiber sind.

**5.** Elektromodulierte Struktur nach einem der vorhergehenden Ansprüche, die ferner eine Monomodelaservorrichtung umfasst.

**6.** Sender, der eine elektromodulierte Struktur nach Anspruch 1 und einen Laser, der monolithisch in den Elektroabsorptionsmodulator integriert ist, umfasst, wobei der Laser ein Laser mit verteilter Rückkopplung ist.

**7.** Sender nach Anspruch 6, wobei der Laser dazu ausgelegt ist, ein optisches Signal zu erzeugen, das via den ersten und den zweiten Bereich des Elektroabsorptionsmodulators zu einem Ausgang des Senders zu leiten ist.

**8.** Sender nach einem der Ansprüche 6 bis 7, wobei der erste und der zweite Bereich des Elektroabsorptionsmodulators jeweilige verschiedene Längen aufweisen.

**9.** Verfahren zum Modulieren eines optischen Signals in einem optischen Sender, um ein pulsamplitudenmoduliertes Ausgangssignal mit mehreren Pegeln zu erzeugen, wobei das Verfahren Folgendes umfasst:

Vorspannen eines ersten und eines zweiten Bereichs eines Elektroabsorptionsmodulators des Senders unter Verwendung von jeweiligen verschiedenen angelegten elektrischen Feldern, wobei das Verfahren **dadurch gekennzeichnet ist, dass** der erste und der zweite Bereich des Elektroabsorptionsmodulators mit Spannungen vorgespannt werden, die einem minimalen und einem maximalen Pegel der Extinktionskurven des ersten und des zweiten Bereichs des Modulators entsprechen.

**10.** Verfahren nach Anspruch 9, das ferner das Vorspannen eines ersten und eines zweiten Bereichs eines Elektroabsorptionsmodulators mit Spannungen, die einem minimalen und einem maximalen Pegel der Extinktionskurven des ersten und des zweiten Bereichs des Modulators entsprechen, umfasst, wo die Ableitung d(ER)/dV null ist.

**11.** Verfahren nach einem der Ansprüche 9 oder 10, wobei der erste und der zweite Bereich des Elektroabsorptionsmodulators unter Verwendung von ausgewählten Spannungssignalen, die an Elektroden des ersten und des zweiten Bereichs des Elektroabsorptionsmodulators angelegt werden, vorgespannt werden.

**12.** Verfahren nach Anspruch 11, wobei die Spannungssignale ausgewählt werden, um eine Zweibitsequenz für das Ausgangssignal zu erzeugen.

**Revendications**

**1.** Structure électro-modulée comprenant :

un modulateur à électro-absorption ; et des premier et second circuits d'attaque pour appliquer de façon indépendante des premier et second champs électriques respectifs à des première et seconde sections du modulateur, de manière à moduler un signal optique pour produire un signal de sortie à modulation multiniveau en amplitude d'impulsion, **caractérisée en ce que** :
les premier et second circuits d'attaque sont conçus pour polariser les première et seconde sections du modulateur à l'aide de tensions appliquées respectives correspondant à des niveaux minimum et maximum des courbes d'extinction des première et seconde sections du modulateur.

**2.** Structure électro-modulée telle que revendiquée dans la revendication 1, dans laquelle la première section du modulateur est plus courte que la seconde section du modulateur.

**3.** Structure électro-modulée telle que revendiquée dans l'une quelconque des revendications précédentes, dans laquelle les longueurs respectives, L, des première et seconde sections du modulateur sont choisies en fonction d'un rapport d'extinction, ER (*extinction ratio*), des sections, selon :

$$ER = \exp(-\Delta\alpha.\Gamma.L/10)$$

où $\Gamma$ est le confinement optique d'un mode du dispositif laser, et $\Delta\alpha$ est la variation d'absorption d'une section du modulateur avec une tension appliquée.

**4.** Structure électro-modulée telle que revendiquée dans l'une quelconque des revendications précédentes, dans laquelle les premier et second circuits d'attaque sont des circuits d'attaque synchronisés à limitation de courant.

**5.** Structure électro-modulée telle que revendiquée dans l'une quelconque des revendications précédentes, comprenant en outre un dispositif laser monomode.

**6.** Émetteur comprenant une structure électro-modulée telle que revendiquée dans la revendication 1, et un laser intégré de façon monolithique au modulateur à électro-absorption, dans lequel le laser est un laser à réaction distribuée.

7. Émetteur tel que revendiqué dans la revendication 6, dans lequel le laser est conçu pour produire un signal optique devant passer par les première et seconde sections du modulateur à électro-absorption pour atteindre une sortie de l'émetteur.

8. Émetteur tel que revendiqué dans l'une quelconque des revendications 6 et 7, dans lequel les première et seconde sections du modulateur à électro-absorption ont des longueurs respectives différentes.

9. Procédé permettant de moduler un signal optique dans un émetteur optique pour produire un signal de sortie à modulation multiniveau en amplitude d'impulsion, le procédé comprenant les étapes suivantes :
polariser les première et seconde sections d'un modulateur à électro-absorption de l'émetteur, à l'aide de champs électriques appliqués, différents, respectifs, le procédé étant **caractérisé en ce que** :
les première et seconde sections du modulateur à électro-absorption sont polarisées à des tensions correspondant à des niveaux minimum et maximum des courbes d'extinction des première et seconde sections du modulateur.

10. Procédé tel que revendiqué dans la revendication 9, comprenant en outre la polarisation des première et seconde sections du modulateur à électro-absorption à des tensions correspondant à des niveaux minimum et maximum des courbes d'extinction des première et seconde sections du modulateur, où la dérivée d(ER)/dV est nulle.

11. Procédé tel que revendiqué dans l'une quelconque des revendications 9 et 10, dans lequel les première et seconde sections du modulateur à électro-absorption sont polarisées à l'aide de signaux de tension choisis, appliqués à des électrodes des première et seconde sections du modulateur à électro-absorption.

12. Procédé tel que revendiqué dans la revendication 11, dans lequel les signaux de tension sont choisis pour produire une séquence de deux bits pour le signal de sortie.

Figure 1

Figure 2

Figure 3

401 | Bias first and second sections of electro-absorption modulator of transmitter using respective different applied electric fields

403 | Generate multi-level pulse amplitude modulated output signal

Figure 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160365929 A

- US 2005275920 A